# EUROPEAN PATENT APPLICATION

(11) **EP 1 167 981 A1**
(43) Date of publication of application: **02.01.2002**
(21) Application number: 01304944.0
(22) Date of filing: 06.06.2001
(51) Int. Cl.: G01R 13/34, G01R 31/28, G01R 31/319

(54) **Method of operating a measurement instrument using a spreadsheet program**

(30) Priority: 19.06.2000 US 597892
(71) Applicant: Tektronix, Inc., Beaverton, OR 97077-0001 (US)
(72) Inventor: Damm, Wendell W., Beaverton, Oregon 97007 (US)
(74) Representative: Burke, Steven David

(57) **Abstract**

A measurement instrument operates under an instrument operation program, using a spreadsheet program which supports a function for supplying an operating command to the instrument operation program for controlling operation of the measurement instrument. The function includes a reference to a cell of the spreadsheet as a formal parameter which forces the spreadsheet program to calculate the function in the event that the value in the referenced cell changes, whereby the function is made dependent on the referenced cell.

## Description

### Background of the Invention

This invention relates to a measurement instrument with a personal computer graphical user interface (GUI).

A user of a digital storage oscilloscope may develop a procedure for performing a particular test. The procedure might involve turning on a power supply to a device under test, starting an arbitrary waveform generator, which will supply a test signal to the DUT, acquiring waveform data, and making a measurement on the waveform data. It might be necessary to repeat this procedure many times, with different devices, which can be tedious and give rise to problems of repeatability.

The conventional digital storage oscilloscope includes a display controller which controls the display parameters, e.g. time/div., volts/div. and vertical offset, in response to front panel controls of the instrument. Desired values of the display parameters and other operating parameters, such as sampling rate, can be supplied to the oscilloscope over a standard communication interface such as GPIB (general purpose interface bus), which allows the oscilloscope to be controlled by a separate instrument. Further, actual values of the operating parameters of the oscilloscope can be read from the oscilloscope and supplied to a separate instrument over GPIB.

Commercially available data acquisition modules having much of the data acquisition functionality of a digital storage oscilloscope are able to digitize a signal and provide an output that enables the waveform of the signal to be displayed using the monitor of a conventional personal computer. Commercially available data acquisition software allows data values acquired using a data acquisition module to be displayed on the computer's monitor in a spreadsheet. The data acquisition software also allows the spreadsheet to display certain acquisition parameters. However, many oscilloscope users find commercially available data acquisition software hard to use and inflexible. Customization of commercially available data acquisition software can be expensive.

Many users of measurement instruments such as oscilloscopes transfer data from the measurement instrument to a personal computer for purposes of recording the data for later use, analyzing the data and/or preparing reports. Many oscilloscope users are familiar with operation of spreadsheet programs, such as Microsoft Excel, which can be used for recording and analyzing data.

The conventional spreadsheet is organized as a rectangular array of cells and the user typically enters a value or formula in a cell. In the event that the user enters a value in a cell, the cell displays that value; and in the event that the user enters a formula, the cell displays the value returned by that formula. Frequently, the formula in a given cell refers to another cell and the value in that other cell is then used as an argument in the formula. Using suitable interfaces, the spreadsheet can use a value provided by another application program running on the computer as an argument in the formula and the value returned by the formula can be provided to another application program running on the computer.

The convenience of a spreadsheet program depends at least partly on its speed of operation, and the speed of operation depends on the procedure for updating the spreadsheet when a value in one of the cells changes. In particular, in order to minimize the time taken to update the spreadsheet when the value in one of the cells changes, the program might not recalculate the entire spreadsheet when the value in a single cell changes but only the cells that are dependent on the cell that contains the changed value, i.e. the cells that refer through the spreadsheet, directly or indirectly, to the cell that contains the changed value.

Consider the following simple example:

### Example 1

Cell A1 contains the value 2
Cell A2 contains the value 4
Cell A3 contains the formula =A1+A2 (and displays the result of 6)
Cell A4 contains the value 3
Cell A5 contains the formula =A3/A4 (and displays the result of 2)

Cells A1 through A5 are not used in any worksheet formulas in any other cells.

If the user changes a value in any cell outside the block A1-A5, the formulas in cells A3 and A5 are not recalculated.

If the user changes the value in cell A4 from 3 to 2, the formula in cell A5 is recalculated and the result of 3 is displayed but the formula in cell A3 is not recalculated.

If the user changes the value in cell A1, the program recalculates both the formula in cell A3 and the formula in cell A5.

Moreover, it is not always possible for the typical user of a spreadsheet program to predict the sequence in which the cells will be recalculated.

The commercially available spreadsheet programs, such as Microsoft Excel, have numerous built-in functions that can be used to construct formulas but it is also possible, using commercially available development resources, such as Excel Developer's Kit published by Microsoft Press, to create an add-in that provides non-standard functions. It is also possible to write an add-in that provides non-standard functions using Visual Basic for Applications.

The functions have prescribed arguments and the arguments may generally be entered either as a value or as a cell reference. In the event that the argument is a cell reference and the referenced cell contains a value, if the value in the referenced cell changes, the function is recalculated and the result returned by the function changes accordingly. If the user attempts to include an additional argument, the function will generally return an error message.

### Summary of the Invention

In accordance with a first aspect of the invention there is provided a method of operating a measurement instrument under an instrument operation program, using a spreadsheet program which supports a function for supplying an operating command to the instrument operation program for controlling operation of the measurement instrument, wherein the function includes a reference to a cell of the spreadsheet as a formal parameter which forces the spreadsheet program to calculate the function in the event that the value in the referenced cell changes, whereby the function is made dependent on the referenced cell.

In accordance with a second aspect of the invention there is provided a method of operating a measurement instrument under an instrument operation program, using a spreadsheet program which supports a first function supplying a first operating command to the instrument operation program for controlling operation of the measurement instrument and a second function for supplying a second command to the instrument operation program for controlling operation of the measurement instrument, including placing the first function in a formula in a first cell of a spreadsheet, and placing the second function in a formula in a second cell of the spreadsheet, and wherein the second function includes a reference to the first cell of the spreadsheet as a formal parameter which forces the spreadsheet program to calculate the second formula in the event that the first formula is recalculated, whereby the second formula is made dependent on the first formula.

### Brief Description of the Drawings

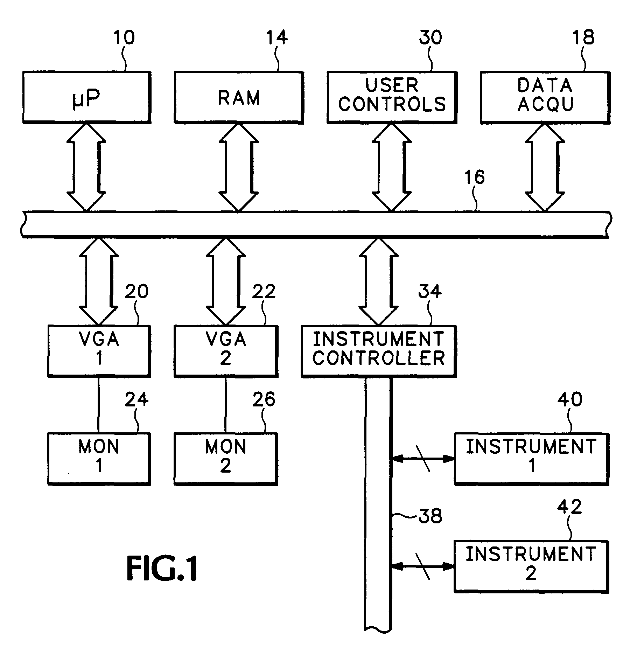

For a better understanding of the invention, and to show how the same may be carried into effect, reference will now be made, by way of example, to the accompanying drawing, the single Figure of which is a schematic block diagram of a digital storage oscilloscope in accordance with the present invention.

### Detailed Description

The oscilloscope illustrated in the drawing is based on a personal computer architecture and includes a main board or mother board (not shown) which carries a CPU 10 and associated components, such as RAM 14, which communicate over a standard bus 16. The oscilloscope also includes a data acquisition module 18 which is plugged into a suitable connector on the main board and is thereby connected to the bus 16. The data acquisition module 18 has a signal input terminal (not shown) which is connected through suitable interface circuitry (not shown) to a test point of a device under test. The signal evolving at the test point is supplied to the data acquisition module 18 and is digitized to create a waveform record which is stored in acquisition memory of the acquisition module.

The CPU 10 runs under the Windows 98 operating system, which allows use of multiple display adapters. The oscilloscope includes two display adapters 20 and 22 driving respective monitors 24 and 26. The CPU runs both a data acquisition and display program and a spreadsheet program. The window in which the data acquisition and display program runs is displayed by the monitor 24. The data acquisition and display program interacts with the acquisition module 18 and allows the monitor 24 to display the waveform of the signal that is acquired by the data acquisition module 18. The oscilloscope has front panel controls 30 which interact with the data acquisition and display program and allow the user to adjust the acquisition and display parameters.

The computer bus 16 communicates with an instrument controller 34, which is turn communicates over an external bus 38, such as GPIB, with other instruments 40, 42. The instruments 40 and 41 are auxiliary instruments that are used with the oscilloscope in carrying out a test. For example, the instruments may be a power supply for supplying operating power to the device under test and an arbitrary waveform generator for supplying a signal to an input terminal of the device under test. In a particular case, there may be more or fewer than two auxiliary instruments.

The window in which the spreadsheet program runs is displayed by the monitor 26. The spreadsheet program is used to control operation of the oscilloscope, providing an alternative to the front panel controls 30. For this purpose, the spreadsheet program includes an add-in which supplies non-standard functions which are specific to the data acquisition and display operations performed by an oscilloscope. The nature of the add-in depends on the desired non-standard functions, but a suitable add-in for controlling many standard operations of an oscilloscope can be created by a person of ordinary skill in the art with the aid of standard reference sources.

The spreadsheet program interacts with the data acquisition and display program and supplies values to, and reads values from, the data acquisition and display program. The spreadsheet program also interacts with the instrument controller 34 to supply commands to, and receive responses from, the instruments 40 and 42.

Use of an add-in to control operation of the oscilloscope can present some difficulties. Consider the case in which two of the functions provided by the add-in are SetVerticalOffset("CHn",Addr) and GetVerticalOffset("CHn"), where CHn represents the nth channel of the oscilloscope. The formula =SetVerticalOffset("CH1",Addr) causes the spreadsheet program to supply the value in the spreadsheet cell having the address Addr to the data acquisition and display program as the desired value of the vertical offset of channel 1 and the formula =GetVerticalOffset("CH1") causes the spreadsheet program to read the actual value of the vertical offset of channel 1 from the data acquisition and display program and display this value in the cell containing the formula. An add-in that will provide functions to perform these operations can be created by a person of ordinary skill in the art.

### Example 2

Cell A1 contains the value 2
Cell A2 contains the formula =SetVerticalOffset("CH1",A1)

The oscilloscope operation is linked to Cell A2 and responds to change in the value of the function SetVerticalOffset("CH1"). In the case of this example, the vertical offset of channel 1 is 2 divisions. If we then change the value in cell A1 to 3, the value of the function SetVerticalOffset("CH1") changes to 3 and we can observe this on the display of the monitor 24.

It might be desired to display the current set up of the oscilloscope so that the change in vertical offset can be verified. Consider the following modification of Example 2:

### Example 3

Cell A1 contains the value 2
Cell A2 contains the formula =SetVerticalOffset("CH1",A1)
Cell A3 contains the formula =GetVerticalOffset("CH1")

If the user invokes the recalculate command, cell A3 will display the value 2.

If we now change the value in cell A1 to 3, cell A2 is calculated and the vertical offset of the channel 1 waveform displayed on the monitor 24 changes to 3 divisions. Since the formula in cell A3 does not refer through the spreadsheet to a cell whose value has changed, and is therefore not dependent on a cell whose value has changed, the spreadsheet program treats the formula in cell A3 as being independent of the formula in cell A2 and does not recalculate cell A3. Consequently, when the value in cell A1 is changed, the value in cell A3 is not automatically recalculated.

In some cases, the consequence of cells not being automatically recalculated is not severe. However, in other cases it may be important that operations that are controlled by cell values be performed in a known order.

Consider now a modification of Example 3:

### Example 4

Cell A1 contains the value 2
Cell A2 contains the formula =SetVerticalOffset("CH1", A1)
Cell A3 contains the formula =GetVerticalOffset("CH1", A2)

In this case, the formula in cell A3 contains an additional formal parameter A2, beyond any that might be present in the function GetVerticalOffset("CHn"). This additional formal parameter does not affect the interaction between the spreadsheet program and the data acquisition and display program, but the reference to cell A2 in cell A3 makes cell A3 dependent on cell A2 and forces the spreadsheet program to recalculate cell A3 if cell A2 changes. Therefore, if we change the value in cell A1 from 2 to 3, the vertical offset of the channel 1 waveform display on the monitor 100 changes from 2 divisions to 3 divisions and since the value of cell A2 changes the program also recalculates cell A3 and reads the value of the vertical offset of channel 1 from the data acquisition and display program and displays this value in cell A3. Thus, the value displayed in cell A3 changes from 2 to 3.

It will be appreciated that including the additional formal parameter in the function GetVerticalOffset necessitates a change in the function, and hence in the add-in that supplies the function, but modification of a function to include an additional parameter is within the skill of the art.

Use of additional formal parameters in spreadsheet functions allows the user to control the sequence in which cells will be recalculated and hence the sequence in which operations performed in response to those cells will be performed. For example, if the add-in provides the functions StartPowerSupply("PS1", A1) for starting a specified power supply, the function GetPowerSupplyStatus("PS1", A2) for retrieving the status of a specified power supply, the function StartAWG("AWG1", A3) for starting a specified arbitrary waveform generator, the function GetAWGStatus("AWG1", A4) for retrieving the status of a specified arbitrary waveform generator, the function AcquireWaveformData("CH1", "MEM1", A5) for acquiring waveform data and storing the data in a specified memory range, and the formula MakeMeasurement("MEM1", A6) for making a defined measurement on the waveform data in a specified memory range, the user can enter the following formulas:
Cell A2 contains the formula = StartPowerSupply("PS1", A1)
Cell A3 contains the formula = GetPowerSupplyStatus("PS1", A2)
Cell A4 contains the formula = StartAWG("AWG1", A3)
Cell A5 contains the formula = GetAWGStatus("AWG1", A4)
Cell A6 contains the formula = AcquireWaveformData
   ("CH1","MEM1", A5)
Cell A7 contains the formula =MakeMeasurement("MEM1", A6)

When the user changes the value in cell A1, the spreadsheet program will recalculate cells A2-A7 in that order because each of cells A2-A7 contains a reference, as an additional formal parameter, to the preceding cell. Consequently, after the value in cell A1 changes, the formula =StartPowerSupply("PS1", A1) is executed and the spreadsheet program issues a command to start the power supply. After the power supply has been started, cell A3 is calculated and the program issues a command to retrieve the power supply status. Then cell A4 issues a command to start the arbitrary waveform generator and cell A5 issues a command to retrieve the arbitrary waveform generator status. Cell A6 issues a command to acquire waveform data for channel 1 and cell A7 issues a command to make a measurement on the data stored in the designated memory. It will therefore be appreciated that the measurement cannot be made until all the preceding steps have been completed. This allows the user to automate the steps for carrying out the repetitive operation of making a measurement on numerous devices without creating problem of repeatability.

The user can add further steps, such as stopping the arbitrary waveform generator and stopping the power supply so that the oscilloscope will be ready for the next measurement.

By including a suitable additional formal parameter in a function that acts on an instrument outside the PC, it is possible to ensure that the function will be performed if the value in the cell referred to in the additional formal parameter changes.

Furthermore, the spreadsheet functions are integrated into the function wizard and Help systems, allowing the user to modify the functions and generate custom functions and to access help information.

It will be appreciated that the invention is not restricted to the particular embodiment that has been described, and that variations may be made therein without departing from the scope of the invention as defined in the appended claims and equivalents thereof. Unless the context indicates otherwise, a reference in a claim to the number of instances of an element, be it a reference to one instance or more than one instance, requires at least the stated number of instances of the element but is not intended to exclude from the scope of the claim a structure or method having more instances of that element than stated.

## Claims

1. A method of operating a measurement instrument under an instrument operation program, using a spreadsheet program which supports a function for supplying an operating command to the instrument operation program for controlling operation of the measurement instrument, wherein the function includes a reference to a cell of the spreadsheet as a formal parameter which forces the spreadsheet program to calculate the function in the event that the value in the referenced cell changes, whereby the function is made dependent on the referenced cell.

2. A method according to claim 1, wherein the measurement instrument is an oscilloscope and the function supplies a command affecting data acquisition and display of the oscilloscope.

3. A method of operating a measurement instrument under an instrument operation program, using a spreadsheet program which supports a first function supplying a first operating command to the instrument operation program for controlling operation of the measurement instrument and a second function for supplying a second command to the instrument operation program for controlling operation of the measurement instrument, including:
placing the first function in a formula in a first cell of a spreadsheet, and
placing the second function in a formula in a second cell of the spreadsheet,
and wherein the second function includes a reference to the first cell of the spreadsheet as a formal parameter which forces the spreadsheet program to calculate the second formula in the event that the first formula is recalculated, whereby the second formula is made dependent on the first formula.
